(19) Europäisches Patentamt
European Patent Office
Office européen des brevets

(11) **EP 4 650 630 A1**

(12) **EUROPEAN PATENT APPLICATION**

(43) Date of publication:
**19.11.2025 Bulletin 2025/47**

(21) Application number: **25174640.0**

(22) Date of filing: **06.05.2025**

(51) International Patent Classification (IPC):
**F16K 3/02** (2006.01)   **F16K 11/22** (2006.01)
**F16K 31/00** (2006.01)   **H05K 7/20** (2006.01)

(52) Cooperative Patent Classification (CPC):
**F16K 31/002; F16K 3/0254; F16K 3/0281;
F16K 11/22; H05K 7/20836**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **14.05.2024   US 202463647205 P
25.04.2025   US 202519190100**

(71) Applicant: **Vertiv Corporation
Westerville, OH 43082 (US)**

(72) Inventor: **MENOCHE, John Paul
Westerville (US)**

(74) Representative: **Beal, James Michael et al
Kilburn & Strode LLP
Lacon London
84 Theobalds Road
London WC1X 8NL (GB)**

(54) **SYSTEM FOR CONTROLLING FLOW OF COOLANT AND METHOD FOR THE SAME**

(57)   A fluid control system (114) for a cooling system is disclosed. The fluid control system includes a fluid inlet (204), a fluid outlet (206), and a fluid inlet control valve (208) configured to control an incoming flow of the fluid along the fluid inlet. The fluid inlet control valve includes a fluid inlet gate (210) and an inlet valve actuator (212) coupled to the fluid inlet gate that is in thermal communication with the fluid outlet, wherein an increase in temperature of the fluid outlet causes the inlet valve actuator to decrease a restriction of the incoming flow of the fluid by the fluid inlet gate. The fluid control system further includes a fluid outlet control valve (230) that includes a fluid outlet gate (232) and an outlet valve actuator (233) coupled to the fluid outlet gate that is in thermal communication with the fluid inlet.

FIG.2A

EP 4 650 630 A1

## Description

CROSS-REFERENCE TO RELATED APPLICATIONS

The present application claims the benefit of U.S. Provisional Patent Application No. 63/647,205 filed May 14, 2024 and of U.S. Non-Provisional Patent Application No. 19/190,100 filed April 25, 2025.

TECHNICAL FIELD

The present disclosure relates to cooling systems for electronic equipment, and more particularly to systems and methods for controlling the flow of coolant through the cooling systems.

BACKGROUND

Telecommunication and computing industries rely on cooling systems to keep temperature-sensitive equipment (e.g., servers, computers) operating under rated or normal environmental conditions. These cooling systems often utilize heat exchangers, such as liquid heat exchangers as part of the cooling system infrastructure. Heat exchangers often do not provide flow control which is often needed to preserve available supply head pressure and maintain constant fluid change in temperature (dT) (e.g., the difference in temperature between an incoming "cool" coolant and an outgoing "warm" coolant) and/or reduce pumping energy usage. Manually adjusted pressure-dependent or pressure-independent control valves are often used but require adjustment with supply temperature. Automatic pressure, temperature or energy control valves are available, but add considerable cost to each heat exchanger installed. In addition, central controls for control valves can add to project costs.

Accordingly, it may be advantageous to have a cooling system that maintains fluid dT with varying incoming coolant temperatures without the aforementioned cost and labor inputs.

SUMMARY

Accordingly, the present disclosure is directed toward a system and a method for controlling the flow of coolant into a cooling system. In one or more embodiments, the system includes a fluid control system. The fluid control system includes a fluid inlet for receiving a fluid, a fluid outlet for releasing the fluid, and a fluid inlet control valve configured to control an incoming flow of the fluid along the fluid inlet. In one or more embodiments, the fluid inlet control valve includes a fluid inlet gate and an inlet valve actuator coupled to the fluid inlet gate and in thermal communication with the fluid outlet, wherein an increase in temperature of the fluid outlet causes the inlet valve actuator to decrease a restriction of the incoming flow of the fluid by the fluid inlet gate. In one or more embodiments, the fluid control system further includes a fluid outlet control valve configured to control an outgoing flow of the fluid along the fluid outlet. In one or more embodiments, the fluid outlet control valve includes a fluid outlet gate disposed within the fluid outlet and an outlet valve actuator coupled to the fluid outlet gate and in thermal communication with the fluid inlet, wherein an increase in temperature of the fluid inlet causes the outlet valve actuator to decrease a restriction of the outgoing flow of the fluid by the fluid outlet gate.

In one or more embodiments, the inlet valve actuator include an inlet cylinder, an inlet plunger at least partially within the inlet cylinder, and an inlet heat expansion element disposed within the inlet cylinder and configured to expand upon an increase in heat, wherein an expansion of the heat expansion element cause the inlet plunger to translate the inlet plunger relative to the inlet cylinder.

In one or more embodiments, the outlet valve actuator includes an outlet cylinder, an outlet plunger at least partially within the outlet cylinder, and an outlet heat expansion element disposed within the outlet cylinder and configured to expand upon an increase in heat, wherein an expansion of the heat expansion element cause the outlet plunger to translate the outlet plunger relative to the outlet cylinder.

In one or more embodiments of the system, the inlet heat expansion element and the outlet heat expansion element comprise different heat expansion materials with linear displacement profiles in different temperature ranges.

In one or more embodiments, the fluid control system maintains a constant difference in temperature (dt) between the incoming flow of the fluid and the outgoing flow of the fluid within a defined range of temperatures.

In one or more embodiments, the system includes a cabinet door that includes a cooling circuit, wherein the cooling circuit is operatively coupled to the fluid control system.

A method for controlling or changing a flow of fluid within a cooling system to compensate for an increase in incoming fluid temperature, while maintaining a constant difference in temperature (dt) between an incoming flow of the fluid and an outgoing flow of the fluid is disclosed. In one or more embodiments, the method includes transferring heat from an incoming fluid to a fluid inlet. In one or more embodiments, the method includes transferring heat from the fluid inlet to an outlet valve actuator. In one or more embodiments, the method includes actuating the outlet valve actuator based on a transfer of heat from the fluid inlet. In one or more embodiments, the method includes decreasing a restriction of the outgoing flow of the fluid by a fluid outlet gate. In one or more embodiments, the method includes increasing the outgoing flow of the fluid based on a decrease in restriction by the fluid outlet gate.

In one or more embodiments, the method includes increasing the temperature of an outgoing fluid based upon increase in incoming fluid temperature. In one or more embodiments, the method includes transferring heat from the outgoing fluid to a fluid outlet. In one or more embodiments, the method includes transferring heat from the fluid outlet to an inlet valve actuator. In one or more embodiments, the method includes actuating the inlet valve actuator based on the transfer of heat from the fluid outlet. In one or more embodiments, the methods include decreasing a restriction of the incoming flow of the fluid by a fluid inlet gate. In one or more embodiments, the methods include increasing the incoming flow of the fluid based on a decrease in restriction by the fluid inlet gate.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

BRIEF DESCRIPTION OF DRAWINGS

The numerous advantages of the disclosure may be better understood by those skilled in the art by reference to the accompanying figures.

FIG. 1 illustrates a block diagram of a cooling system, in accordance with one or more embodiments of the disclosure.

FIG. 2A illustrates a cross-sectional view of the fluid control system, in accordance with one or more embodiments of the disclosure.

FIG. 2B illustrates a reverse pan view of the fluid control system, in accordance with one or more embodiments of the disclosure.

FIG. 3 illustrates a graph depicting how an expansion of a heat expansion element expands as a function of temperature, in accordance with one or more embodiments of the disclosure.

FIG. 4 illustrates a graph depicting how an expansion of a two heat expansion elements with different, yet overlapping, linear placement profiles expand as a function of temperature, in accordance with one or more embodiments of the disclosure.

FIG. 5 illustrates a graph depicting how an expansion of a heat expansion element expands as a function of temperature within a defined temperature range, in accordance with one or more embodiments of the disclosure.

FIG. 6 illustrates the cooling system with a flow of incoming fluid and outgoing fluid, in accordance with one or more embodiments of the disclosure.

FIG. 7 illustrates a drawing depicting how fluid inlet control valves and fluid outlet control valves operating in an "anti-series" configuration are affected by load changes and incoming fluid temperature changes, in accordance with one or more embodiments of the disclosure.

FIG. 8A and FIG. 8B illustrate process flow diagrams depicting steps of a method, in accordance with one or more embodiments of the disclosure.

DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed is a fluid cooling system for a cabinet door, a cabinet wall, a cabinet, or other enclosure. The fluid cooling system includes a fluid control system that includes a set of valves that maintains a constant dT between incoming "supply" fluid and outgoing fluid even when the temperature of the incoming fluid fluctuates. The fluid control system automatically adjusts to temperature changes in the incoming fluid and does not require any electronic componentry for control, therefore requiring less labor and expense costs than other control systems.

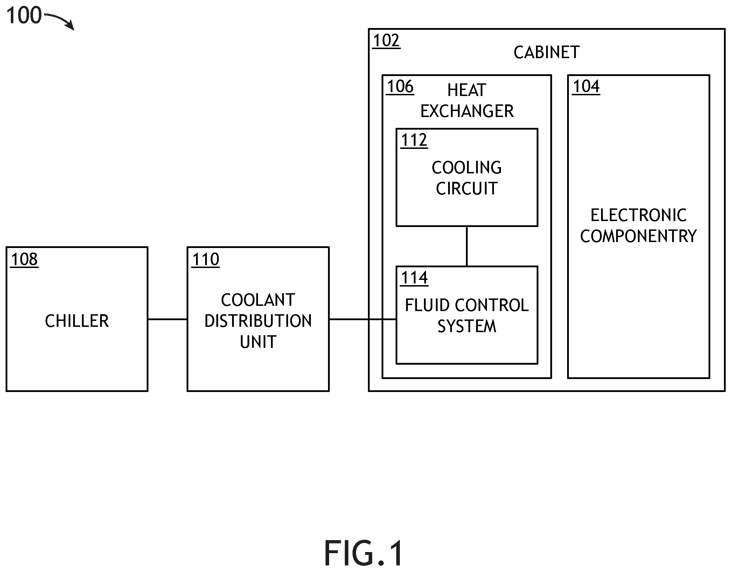

In embodiments, as illustrated in FIG. 1, a cooling system 100 is presented, in accordance with one or more embodiments of the disclosure. The cooling system 100 may include a cabinet 102 for storing electronic componentry 104 such as computer equipment or telecommunication equipment (e.g., servers) and a heat exchanger 106. The heat exchanger 106 may include fluid (e.g., air and/or liquid) heat exchangers. For example, the heat exchanger 106 may circulate liquid coolants such as water or propylene glycol. The heat exchanger 106 may receive chilled coolant (e.g., incoming fluid) directly from a chiller 108, or may receive chilled coolant from a coolant distribution unit 110 that has received the chilled coolant from the chiller 108. A cooling circuit 112 (e.g., a liquid cooling circuit) within the heat exchanger 106 receives the incoming fluid and returns outgoing fluid that has been warmed by the transfer of heat from the electronic componentry 104. Control of the flow of fluid to and from the cooling circuit is provided by a fluid control system 114. The fluid control system 114 acts as a differential temperature valve for the heat exchanger 106, maintaining a constant fluid difference in temperature (dT) between incoming fluid and outgoing fluid. In embodiments, the cooling system 100 may include one or more of the fluid control system 114, the cooling circuit 112, the coolant distribution unit 110, the chiller 108, the heat exchanger 106, the electronic componentry 104, the cabinet 102, or a part of the cabinet 102 (e.g., a cabinet door or cabinet wall that includes the heat exchanger 106).

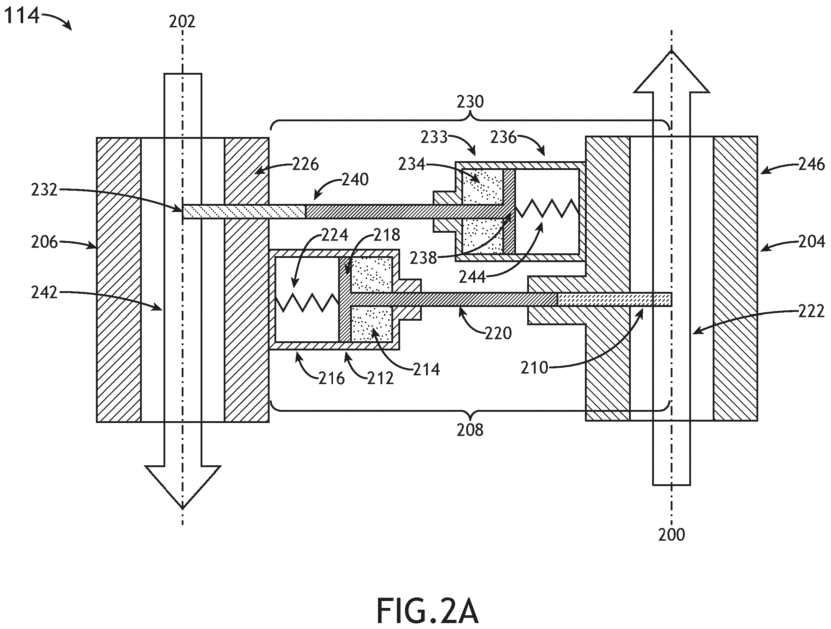

FIG. 2A illustrates a cross-sectional view of the fluid control system 114, in accordance with one or more embodiments of the disclosure. The fluid control system 114 controls the flow of incoming fluid 200 from the chiller 108 and/or coolant distribution unit 110 to the heat exchanger 106 and the flow of outgoing fluid 202 from the heat exchanger 106 to the chiller 108 and/or coolant distribution unit 110, the outgoing fluid 202 generally being warmer than the incoming fluid 200. The fluid may be any fluidic substance (e.g., air and/or gas) that can accept heat transferred from the electronic componentry 104.

In embodiments, the fluid control system 114 includes a fluid inlet 204 or receiving incoming fluid 200 (e.g., from the chiller 108 and/or coolant distribution unit 110) and a fluid outlet 206 for releasing the outgoing fluid 202 (e.g., into the chiller 108 and/or coolant distribution unit 110). The fluid inlet 204 and fluid outlet 206 may include any type of pipe or tube for channeling the fluid.

In embodiments, the fluid control system 114 includes a fluid inlet control valve 208 configured to control a flow of the incoming fluid 200. The fluid inlet control valve 208 includes a fluid inlet gate 210 and an inlet valve actuator 212 that controls the ability of the fluid inlet gate 210 to restrict flow of the incoming fluid 200 through the fluid inlet 204.

The fluid inlet control valve 208 may include any type of valve including but not limited to a pinch valve, a gate valve, a ball valve, a butterfly valve, a check valve, a globe valve, and a plug valve. For example, the fluid inlet control valve 208 may include a valve member in the form of a gate valve (e.g., the valve member formed as a gate) as shown in FIG. 2A.

In embodiments, fluid inlet control valve 208 includes a thermostatic expansion valve. The thermostatic expansion valve includes an inlet heat expansion element 214 disposed within an inlet cylinder 216. Upon an increase in heat, the inlet heat expansion element 214 expands, translating an inlet plunger 218 within (e.g., at least partially within) the inlet cylinder 216 and an inlet valve stem 220, which translates the fluid inlet gate 210 into a fluid inlet chamber 222, restricting the flow of the incoming fluid 200. The inlet cylinder 216 may include a spring 224 or other biasing element that biases the inlet cylinder against the inlet plunger 218. Correspondingly, the inlet heat expansion element 214 may shrink upon losing heat. The fluid inlet control valve 208 may include any type of inlet heat expansion element 214 including, but not limited to, wax. For example, the fluid inlet control valve 208 may be a form of a wax motor, whereupon the addition of heat, the wax expands and biases the inlet plunger 218.

In embodiments, the inlet plunger 218 is thermally coupled to (e.g., in thermal communication with) the fluid outlet 206. For example, heat from the outgoing fluid 202, previously warmed by the electronic componentry 104, may be transferred to the wall 226 of the fluid outlet 206, the heat is then transferred to the inlet cylinder 216 and ultimately to the inlet heat expansion element 214, causing the inlet heat expansion element 214 to expand, biasing the inlet plunger 218.

In embodiments, the fluid control system 114 includes a fluid outlet control valve 230 configured to control a flow of the outgoing fluid 202. The fluid outlet control valve 230 includes a fluid outlet gate 232 and an outlet valve actuator 233 that controls the ability of the fluid outlet gate 232 to restrict the flow of the outgoing fluid 202 through the fluid outlet 206.

The fluid outlet control valve 230 may include any type of valve including but not limited to a pinch valve, a gate valve, a ball valve, a butterfly valve, a check valve, a globe valve, and a plug valve. For example, the fluid outlet control valve 230 may include a valve member in the form of a gate valve (e.g., the valve member formed as a gate) as shown in FIG. 2A.

In embodiments, the fluid outlet control valve 230 includes a thermostatic expansion valve. The thermostatic expansion valve includes an outlet heat expansion element 234 disposed within an outlet cylinder 236. Upon an increase in heat, the outlet heat expansion element 234 expands, translating an outlet plunger 238 within the outlet cylinder 236 and an outlet valve stem 240, which translates the fluid outlet gate 232 into a fluid outlet chamber 242, restricting the flow of the outgoing fluid 202. The outlet cylinder 236 may include a spring 244 or other biasing element that biases the outlet cylinder 236 against the outlet plunger 238. The fluid outlet control valve 230 may include any type of heat expansion element 234 including, but not limited to, wax. For example, the fluid outlet control valve 230 may be a form of a wax motor, whereupon the addition of heat, the wax expands and biases the outlet plunger 238.

In embodiments, the outlet plunger 238 is thermally coupled to the fluid inlet 204. For example, if the incoming fluid 200 is increased in temperature (e.g., by switching the supply from the chiller 108 to a warmer but more environmentally efficient source or fluid such as an outside tank when temperatures are low), heat from the incoming fluid 200, may be transferred to a wall 246 of the fluid inlet 204, the heat is then transferred to the outlet cylinder 236 and ultimately to the outlet heat expansion element 234, causing the outlet heat expansion element 234 to expand, biasing the outlet plunger 238.

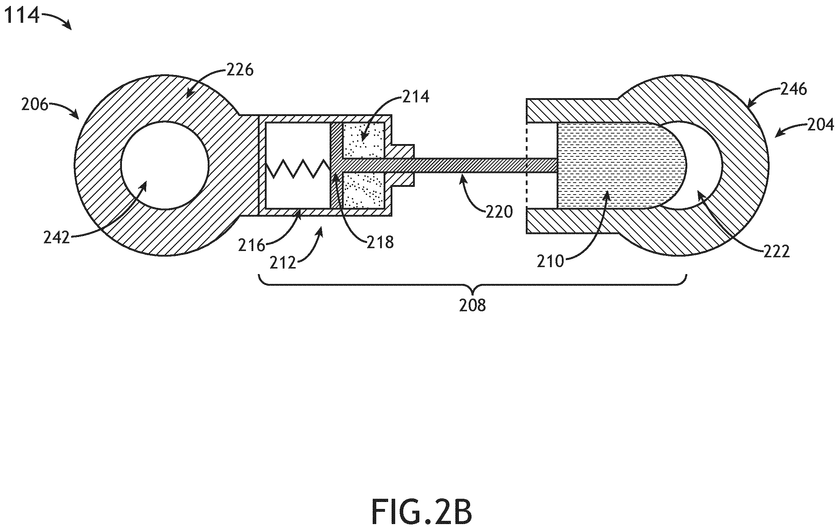

FIG. 2B illustrates a reverse pan view of the fluid control system 114, in accordance with one or more embodiments of the disclosure. The reverse pan view shows the fluid inlet control valve 208, with the fluid outlet control valve 230 hidden behind the fluid inlet control valve 208.

The actions of the fluid inlet control valve 208 and the fluid outlet control valve 230 both adjust to changes within the cooling system 100 that occur when the incoming fluid 200 changes in temperature. For example, if the temperature of the incoming fluid 200 increases, the outlet heat expansion element 234 increases in volume causing the fluid outlet control valve 230 to reduce restriction of the fluid outlet 206 and increase flow of the outgoing fluid 202. Because the outgoing fluid 202 will likely increase in temperature once the higher temperature incoming fluid is further warmed by the electronic componentry 104 and reaches the fluid outlet 206, the inlet heat expansion element 214 will also expand, resulting in an increased flow of the incoming fluid 200.

In another example, if the temperature of the incoming fluid 200 decreases, the outlet heat expansion element 234 decreases in volume causing the fluid outlet control valve 230 to increase restriction of the fluid outlet 206 and decrease flow of the outgoing fluid 202. Because the outgoing fluid 202 will likely decrease in temperature due to the lower temperature of the incoming fluid 200, the inlet heat expansion element 214 will also decrease in volume, resulting in a decreased flow of the incoming fluid 200.

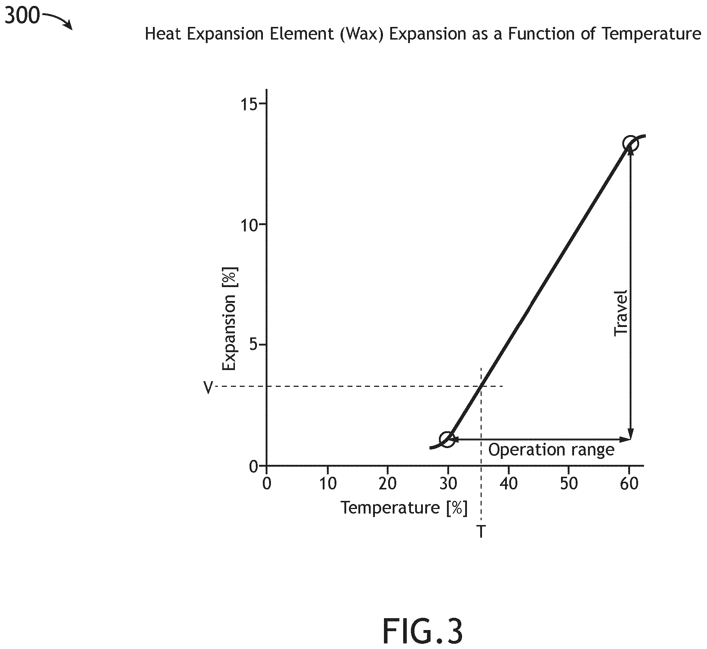

In embodiments, an actuation of the inlet valve actuator 212 is proportional to a temperature of the incoming fluid 200 within a defined range. For example, the fluid inlet control valve 208 may include an inlet heat expansion element 214 that increases in volume (or percent volume) linearly with temperature, as shown in graph 300 of FIG. 3. For example, and as shown in FIG.3, the fluid inlet control valve 208 may include an inlet heat expansion element 214 (e.g., a wax) with a volume that linearly increases in volume in a range between 30°C and 60°C. The fluid inlet control valve 208 may include an inlet heat expansion element 214 with any linear volume-to-temperature characteristic. For example, the inlet heat expansion element 214 may have a volume that linearly increases in volume in a range between 0°C and 100°C, between 10°C and 90°C, between 20°C and 80°C, between 30°C and 70°C, and between 40°C and 60°C. Expansion materials for use in expansion elements, such as expansion wax, are commonly used and may be commercially available, such as the Dilavest[tm] thermostat waxes manufactured by the Paramelt company.

In embodiments, an actuation of the outlet valve actuator 233 is proportional to a temperature of the incoming fluid 200 within a defined range. For example, the fluid outlet control valve 230 may include an outlet heat expansion element 234 that increases in volume (or percent volume) linearly with temperature, as shown in graph 300 of FIG. 3, in accordance with one or more embodiments of the disclosure. For example, and as shown in FIG.3, the fluid outlet control valve 230 may include an outlet heat expansion element 234 (e.g., a wax) with a volume that linearly increases in volume in a range between 30°C and 60°C. The fluid outlet control valve 230 may include an outlet heat expansion element 234 with any linear volume-to-temperature characteristic. For example, the outlet heat expansion element 234 may have a volume that linearly increases in volume in a range between 0°C and 100°C, between 10°C and 90°C, between 20°C and 80°C, between 30°C and 70°C, and between 40°C and 60°C. In embodiments, both the actuation of the inlet valve actuator 212 and the actuation of the outlet valve actuator 233 are proportional to a temperature of their respective fluid (e.g., incoming fluid 200, and outgoing fluid 202) within a defined range, which is based on their respective heat expansion elements (e.g., inlet heat expansion element 214 and outlet heat expansion element 234).

The proportionality between volume and temperature can be explained by the following equations. In general, a volume (V) of an expansion element increases as a function of temperature (T), pressure (p), and time (t), as shown in equation (1):

$$V = f(T, p, t) \qquad (1).$$

Because pressure and time can generally be disregarded within the cooling system 100, the relationship can be simplified, as shown in equation (2):

$$V = f(T) \qquad (2).$$

As shown in FIG. 3, for a range of temperatures (e.g., a defined range of temperatures) between 30°C and 60°C (e.g., $30°C < v < 60°C$), the volume of the expansion element is linearly proportional to temperature (e.g., in a first-order relationship) and dV/dT is positive. Because the volume is linearly proportional to temperature in this range, and a length of a volume (x; also called the length of actuation) is proportional to the volume, x is therefore proportional to temperature, as shown in equation (3):

$$V \propto T \wedge x \propto V \therefore x \propto T \qquad (3)$$

Therefore, the position of a given wax motor actuator (x) is proportional to temperature in a defined range.

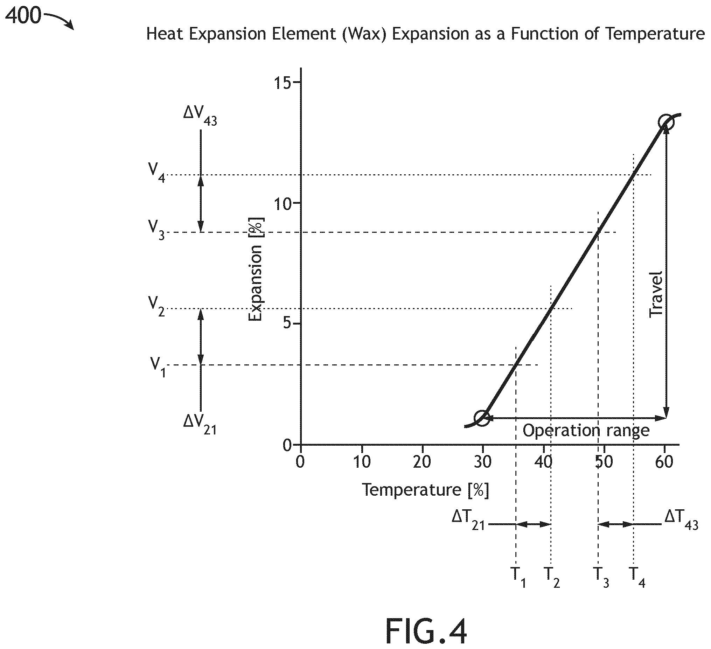

In embodiments, both the actuation of the inlet valve actuator 212 and the actuation of the outlet valve actuator 233 are proportional to a temperature of their respective fluid (e.g., incoming fluid 200, and outgoing fluid 202) within a defined range, which is based on their respective heat expansion elements (e.g., inlet heat expansion element 214 and outlet heat expansion element 234). For example, both the inlet heat expansion element 214 and outlet heat expansion element 234 may include the same heat expansion material having a linear, proportional displacement within a defined temperature range (e.g., between 30°C and 60°C), as shown in graph 400 or FIG. 4, in accordance with one or more embodiments of the disclosure. For example, the graph 400 indicates a change in volume of the outlet heat expansion element 234 ($\Delta V_{21}$) that occurs upon a change in the temperature of the incoming fluid 200 ($\Delta T_{21}$). The graph 400 also indicates a change in volume of the inlet heat expansion element 214 ($\Delta V_{43}$) that occurs upon a change in the temperature of the outgoing fluid 202 ($\Delta T_{43}$). Because dV/dT is constant within this range of temperature, and that all temperature measures ($T_{1-4}$) are on the linear portion of the same curve, if $\Delta T_{21} = \Delta T_{43}$, then $\Delta V_{21} \approx \Delta V_{43}$. In this manner, the cooling system 100 can achieve a constant fluid dT between the incoming fluid 200 and the outgoing fluid 202 even if the temperature of the incoming fluid is variable.

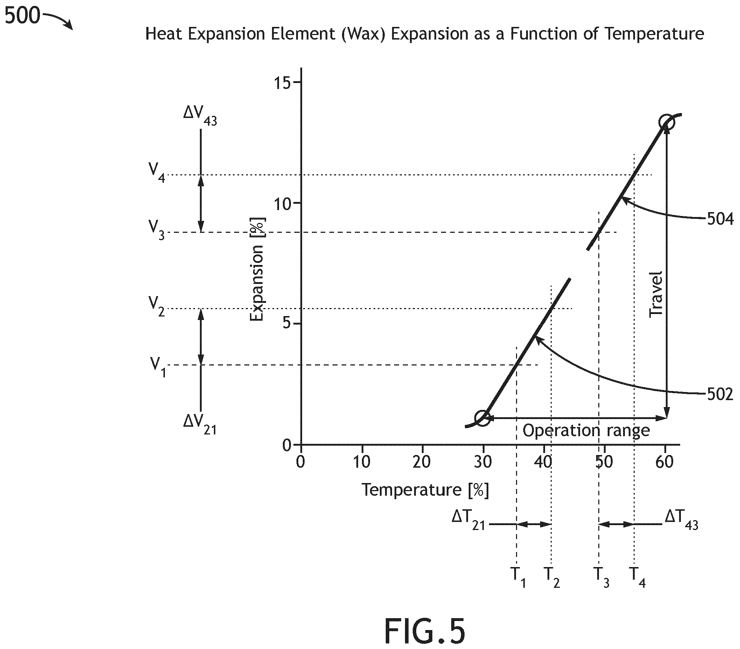

In embodiments, inlet heat expansion element 214 and the outlet heat expansion element 234 include heat expansion material with different linear placement profiles that enables the fluid control system 114 to operate under conditions where the inlet fluid and outlet fluid have considerably different temperatures, as shown in graph 500 of FIG. 5, in accordance with one or more embodiments of the disclosure. For example, the cooling system 100 may include an inlet heat expansion element 214 that includes a first heat expansion material that demonstrates linear expansion proportional to temperature at a low-temperature range, as shown by curve 502, and a second heat expansion material that demonstrates a similar volume expansion proportional to temperature at a high-temperature range, as shown by curve 504. For example, the two curves present profiles of different linear ranges, having either overlapping or discontinuous profiles. The use of two expansion materials with similar volume changes at different temperature ranges may enable the cooling system 100 to operate with highly disparate temperatures (e.g., between 10°C and 90°C), while still maintaining constant fluid dT.

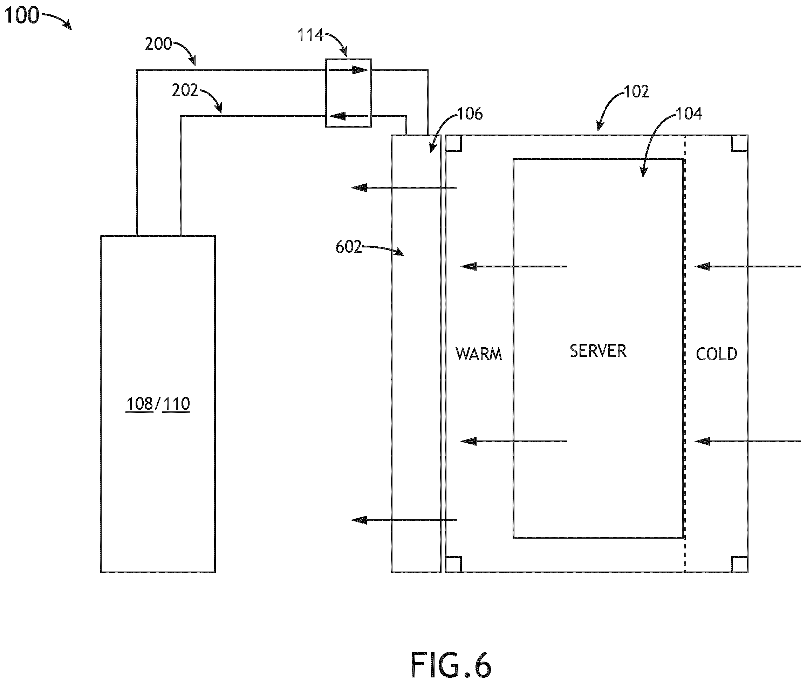

FIG. 6 illustrates the cooling system 100, with the flow of incoming fluid 200 (e.g., chilled fluid) and outgoing fluid 202 (e.g., heated return fluid) indicated, in accordance with one or more embodiments of the disclosure. The fluid control system 114 controls the flow of fluid between the chiller 108 and/or coolant distribution unit 110 and the heat exchanger 106. The heat exchanger 106 may be integrated into a side or door of the cabinet 102. For example, the heat exchanger 106 may be integrated into a door 602 of the cabinet 102 or a wall of the cabinet 102. For instance, the fluid control system may 114 may be implemented with or integrated into a heat exchanger rack door vended by the Vertiv company.

As shown in FIG. 6, cold air is blown through the cabinet via internal or external fans. The electronic componentry 104 (e.g., servers) transfers heat to the air, warming the air. The air is then directed through the heat exchanger 106, transferring heat to the incoming fluid 200. The now-heated fluid is then directed out of the heat exchanger as outgoing fluid to the chiller 108 and/or coolant distribution unit 110.

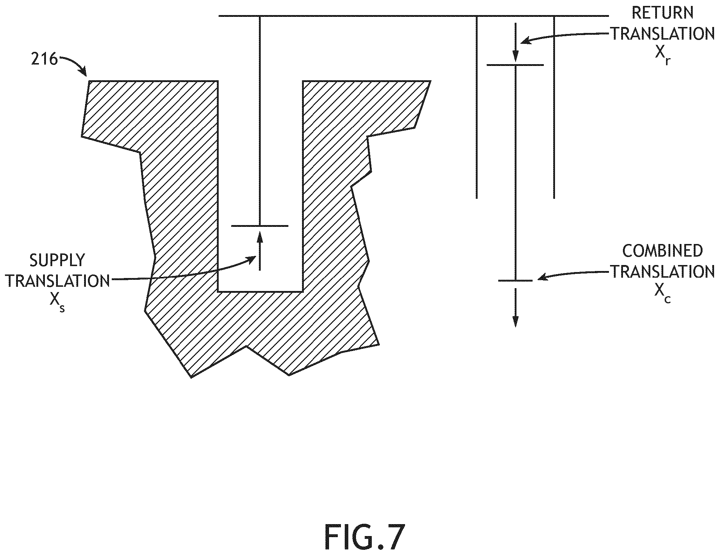

An example of how fluid inlet control valves 208 and fluid outlet control valves 230, operating in an "anti-series" configuration are affected by load changes and incoming fluid temperature changes are shown in FIG. 7, in accordance with one or more embodiments of the disclosure. In this example, the fluid inlet control valves 208 have been set (e.g., manually set) to a constant fluid temperature difference setpoint ($\Delta T_{sp}$). This constant fluid temperature difference setpoint is equivalent to the difference between the initial temperature of the outgoing fluid (e.g., return (r)) and the initial temperature of the incoming fluid (e.g., supply (s)), resulting in the following equation (4):

$$\Delta T_{sp} = T_{r\text{-initial}} - T_{s\text{-initial}} \qquad (4)$$

In this example, dX/dT is constant due to linear function, and the combined translation ($X_c$) is equivalent to the difference between the supply translation ($X_s$) and the return translation ($X_r$) (e.g., Xc = Xs - Xr), which follows that the change in supply translation ($dX_s$) is equivalent to the difference between the change in the supply translation ($dX_s$) and the change in return translation ($dX_r$) (e.g., $dX_c = dX_s - dX_r$).

When considering a change in the temperature of the incoming fluid ($dT_s$), ($dX_s$) changes by the difference between the initial incoming fluid temperature ($T_{s-initial}$) and the final incoming fluid temperature ($T_{s-final}$) multiplied by dX/dT, as shown in equation (5):

$$dX_s = (T_{s-final} - T_{s-initial})*dX/dT \qquad (5).$$

Correspondingly, ($dX_r$) changes by the difference between the initial outgoing fluid temperature ($T_{r-initial}$) and the final outgoing fluid temperature ($T_{r-final}$) multiplied by dX/dT, as shown in equation (6):

$$dX_r \text{ changes by } (T_{r-final} - T_{r-initial})*dX/dT \quad (6)$$

Because dX/dT is constant in the range of temperatures used in this example, (e.g., ($T_{s-final}$ - $T_{s-initial}$) = ($T_{r-final}$ - $T_{r-initial}$)), the change in the combined translation of the two valves ($dX_c$) is approximately zero, as the opposed motions of the of the fluid inlet control valve 208 and the fluid outlet control valve 230 cancel each other out. Correspondingly, if dXc has a non-zero value, the fluid inlet control valve 208 or the fluid outlet control valve 230 will actuate until the original fluid dT is achieved.

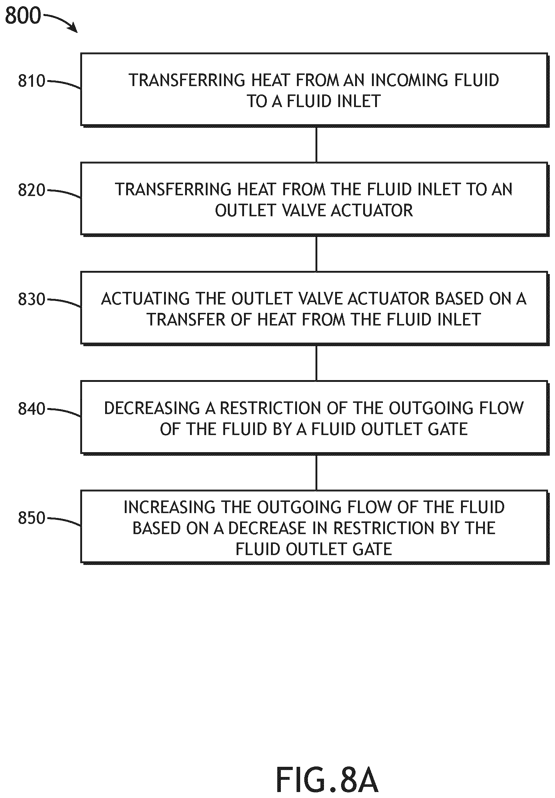

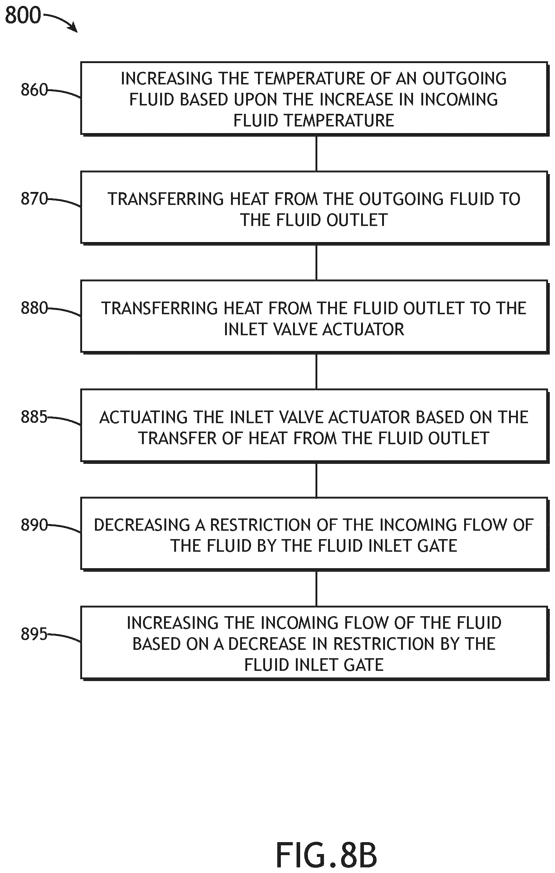

FIG. 8A and FIG. 8B illustrate process flow diagrams depicting steps of a method 800, in accordance with one or more embodiments of the disclosure. The method discloses steps for controlling or changing a flow of fluid within a cooling system 100 to compensate for an increase in incoming fluid temperature, while maintaining a constant difference in temperature (dt) between an incoming flow of the fluid and an outgoing flow of the fluid. The method 800 may be used when switching incoming fluid sources. For example, the method 800 may be used when switching from a traditional chiller 108 and/or coolant distribution unit 110 that provides a low-temperature incoming fluid 200 to a higher-temperature but more environmentally friendly or energy-saving outdoor reservoir (e.g., a naturally cooling reservoir).

In embodiments, the method 800 includes a step 810 of transferring heat from the incoming fluid to a fluid inlet 204. In embodiments, the method 800 includes a step 820 of transferring heat from the fluid inlet to the outlet valve actuator 233 (e.g., the outlet valve actuator 233 and the fluid inlet 204 being thermally coupled). In embodiments, the method 800 includes a step 830 of actuating the outlet valve actuator 233 based on the transfer of heat from the fluid inlet 204 (e.g., via expansion of the outlet heat expansion element 234). In embodiments, the method 800 includes a step 840 of decreasing a restriction of a flow of the outgoing fluid 202 by the fluid outlet gate 232. In embodiments, the method 800 includes a step 850 of increasing the flow of the incoming fluid 200 based on a decrease in restriction by the fluid inlet gate.

Steps 810 to steps 850 in method 800 provide for a change in the rate of flow of the outgoing fluid 202 based on a change in temperature of the incoming fluid 200. Once the incoming fluid 200 reaches the fluid outlet 206 (e.g., as outgoing fluid 202), the temperature of the outgoing fluid 202 will be changed relative to the temperature of the incoming fluid 200.

In embodiments, the method 800 includes a step 860 of increasing the temperature of the outgoing fluid 202 based upon the increase in incoming fluid temperature. In embodiments, the method 800 includes a step 870 of transferring heat from the outgoing fluid 202 to the fluid outlet 206. In embodiments, the method includes a step 880 of transferring heat from the fluid outlet 206 to the inlet valve actuator 212 (e.g., the fluid outlet 206 being thermally coupled to the inlet valve actuator).

In embodiments, the method 800 includes a step 885 of actuating the inlet valve actuator 212 based on the transfer of heat from the fluid outlet 206 (e.g., via the expansion of the inlet heat expansion element 214). In embodiments, the method 800 includes a step 890 of decreasing a restriction of the flow of incoming fluid 200 by the fluid inlet gate 210. In embodiments, the method 800 includes a step 895 of increasing the flow of the incoming fluid 200 based on a decrease in restriction by the fluid inlet gate 210.

Once the flow of the incoming fluid 200 has been changed based on the action of the fluid inlet control valve 208, the fluid control system 114 will have adjusted to the change in temperature of the incoming fluid 200, and the difference in temperature between this new temperature of the incoming fluid 200 and the resultant new temperature of the outgoing fluid 202 will be equivalent to the original temperature of the incoming fluid 200 and the original temperature of the outgoing fluid.

Traditionally, thermostatic valves normally modulate flow to a single temperature, such as a return temperature of a heat exchanger. For example, a thermostatic valve would simply open if the temperature is too high and close if it is too low. Once set, a single thermostatic valve could allow for a constant fluid temperature increase, assuming that the temperature of the incoming fluid 200 does not change. However, if this type of valve system would likely not work correctly the temperature of the incoming fluid would fluctuate, such as to take advantage of an outdoor reset or a change in heat rejection. The fluid control system 114 therefore provides an entirely mechanical system that allows for varying incoming fluid temperatures, reducing labor and costs of more complicated and expensive electronic monitoring and actuation systems. The fluid control system 114 utilizes two valves 208, 230 that, using superposition, negate changes in incoming fluid temperature that would otherwise compromise functionality in a single valve system.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims. The disclosure comprises the following items:

1. A system comprising:
a fluid control system comprising:

a fluid inlet for receiving a fluid;
a fluid outlet for releasing the fluid;
a fluid inlet control valve configured to control an incoming flow of the fluid along the fluid inlet comprising;

a fluid inlet gate; and
an inlet valve actuator coupled to the fluid inlet gate and in thermal communication with the fluid outlet, wherein an increase in temperature of the fluid outlet causes the inlet valve actuator to decrease a restriction of the incoming flow of the fluid by the fluid inlet gate; and

a fluid outlet control valve configured to control an outgoing flow of the fluid along the fluid outlet comprising;

a fluid outlet gate; and
an outlet valve actuator coupled to the fluid outlet gate and in thermal communication with the fluid inlet, wherein an increase in temperature of the fluid inlet causes the outlet valve actuator to decrease a restriction of the outgoing flow of the fluid by the fluid outlet gate.

2. The system of item 1, wherein the inlet valve actuator comprises:

an inlet cylinder;
an inlet plunger at least partially within the inlet cylinder; and
an inlet heat expansion element disposed within the inlet cylinder and configured to expand upon an increase in heat, wherein an expansion of the inlet heat expansion element causes the inlet plunger to translate the inlet plunger relative to the inlet cylinder.

3. The system of item 1 or item 2, wherein the outlet valve actuator comprises:

an outlet cylinder;
an outlet plunger at least partially within the outlet cylinder; and
an outlet heat expansion element disposed within the outlet cylinder and configured to expand upon an increase in heat, wherein an expansion of the outlet heat expansion element causes the outlet plunger to translate the outlet plunger relative to the outlet cylinder.

4. The system of any preceding item, wherein the inlet heat expansion element and the outlet heat expansion element comprise different heat expansion materials with different linear displacement profiles in different temperature ranges.

5. The system of any preceding item, wherein an actuation of the inlet valve actuator and the actuation of the outlet valve actuator are both proportional to a temperature of the fluid within a defined range.

6. The system of any preceding item, wherein the fluid control system maintains a constant difference in temperature between the incoming flow of the fluid and the outgoing flow of the fluid within a defined range of temperatures.

7. The system of any preceding item, wherein the defined range is between 30°C and 60°C.

8. The system of any preceding item, wherein the fluid inlet control valve comprises an expansion valve.

9. The system of any preceding item, wherein the fluid inlet control valve comprises a gate valve.

10. The system of any preceding item, further comprising:
a cabinet door, wherein the cabinet door comprises a liquid coolant circuit operatively coupled to the fluid inlet and the fluid outlet.

11. A system comprising:

a cabinet door comprising a liquid cooling circuit; and
a fluid control system operatively coupled to the liquid cooling circuit comprising:

a fluid inlet for receiving a fluid;
a fluid outlet for releasing the fluid;
a fluid inlet control valve configured to control an incoming flow of the fluid along the fluid inlet comprising;

a fluid inlet gate; and
an inlet valve actuator coupled to the fluid inlet gate and in thermal communication with the fluid outlet, wherein an increase in temperature of the fluid outlet causes the inlet valve actuator to decrease a restriction of the incoming flow of the fluid by the fluid inlet gate; and

a fluid outlet control valve configured to control an outgoing flow of the fluid along the fluid outlet comprising;

a fluid outlet gate disposed within the fluid outlet; and
an outlet valve actuator coupled to the fluid outlet gate and in thermal communication with the fluid inlet, wherein an increase in temperature of the fluid inlet causes the outlet valve actuator to decrease a restriction of the outgoing flow of the fluid by the fluid outlet gate.

12. The system of item 11, wherein the inlet valve actuator comprises:

an inlet cylinder;
an inlet plunger at least partially within the inlet cylinder; and
an inlet heat expansion element disposed within the inlet cylinder and configured to expand upon an increase in heat, wherein an expansion of the inlet heat expansion element causes the inlet plunger to translate the inlet plunger relative to the inlet cylinder.

13. The system of item 11 or item 12, wherein the outlet valve actuator comprises:

an outlet cylinder;
an outlet plunger at least partially within the outlet cylinder; and
an outlet heat expansion element disposed within the outlet cylinder and configured to expand upon an increase in heat, wherein an expansion of the outlet heat expansion element causes the outlet plunger to translate the outlet plunger relative to the outlet cylinder.

14. The system of any of items 11-13, wherein the inlet heat expansion element and the outlet heat expansion element comprise different heat expansion materials with different linear displacement profiles in different temperature ranges.

15. The system of any of items 11-14, wherein an actuation of the inlet valve actuator and the actuation of the outlet valve actuator are both proportional to a temperature of the fluid within a defined range.

16. The system of any of items 11-15, wherein the fluid control system maintains a constant difference in temperature between the incoming flow of the fluid and the outgoing flow of the fluid within a defined range of temperatures.

17. The system of any of items 11-16, wherein the defined range is between 30°C and 60°C.

18. The system of any of items 11-17, wherein the fluid inlet control valve comprises an expansion valve.

19. A method for controlling a flow of fluid within a cooling system to compensate for an increase in incoming fluid temperature, while maintaining a constant difference in temperature between an incoming flow of the fluid and an outgoing flow of the fluid, wherein the cooling system comprises a fluid control system, the method comprising:

transferring heat from an incoming fluid to a fluid inlet of the fluid control system;
transferring heat from the fluid inlet to an outlet valve actuator of a fluid outlet of the fluid control system;
actuating the outlet valve actuator based on a transfer of heat from the fluid inlet;
decreasing a restriction of the outgoing flow of the fluid by a fluid outlet gate of the fluid outlet; and
increasing the outgoing flow of the fluid based on a decrease in restriction by the fluid outlet gate.

20. The method of item 19, further comprising;

    increasing the temperature of an outgoing fluid based upon increase in incoming fluid temperature;

    transferring heat from the outgoing fluid to a fluid outlet;

    transferring heat from the fluid outlet to an inlet valve actuator;

    actuating the inlet valve actuator based on the transfer of heat from the fluid outlet;

    decreasing a restriction of the incoming flow of the fluid by a fluid inlet gate; and

    increasing the incoming flow of the fluid based on a decrease in restriction by the fluid inlet gate.

**Claims**

1. A system comprising:
a fluid control system comprising:

    a fluid inlet for receiving a fluid;

    a fluid outlet for releasing the fluid;

    a fluid inlet control valve configured to control an incoming flow of the fluid along the fluid inlet comprising:

        a fluid inlet gate; and

        an inlet valve actuator coupled to the fluid inlet gate and in thermal communication with the fluid outlet, configured such that an increase in temperature of the fluid outlet causes the inlet valve actuator to decrease a restriction of the incoming flow of the fluid by the fluid inlet gate; and

    a fluid outlet control valve configured to control an outgoing flow of the fluid along the fluid outlet comprising:

        a fluid outlet gate; and

        an outlet valve actuator coupled to the fluid outlet gate and in thermal communication with the fluid inlet, configured such that an increase in temperature of the fluid inlet causes the outlet valve actuator to decrease a restriction of the outgoing flow of the fluid by the fluid outlet gate.

2. The system of claim 1, wherein the inlet valve actuator comprises:

    an inlet cylinder;

    an inlet plunger at least partially within the inlet cylinder; and

    an inlet heat expansion element disposed within the inlet cylinder and configured to expand upon an increase in heat, wherein an expansion of the inlet heat expansion element causes the inlet plunger to translate the inlet plunger relative to the inlet cylinder.

3. The system of claim 1 or claim 2, wherein the outlet valve actuator comprises:

    an outlet cylinder;

    an outlet plunger at least partially within the outlet cylinder; and

    an outlet heat expansion element disposed within the outlet cylinder and configured to expand upon an increase in heat, wherein an expansion of the outlet heat expansion element causes the outlet plunger to translate the outlet plunger relative to the outlet cylinder.

4. The system of claim 3 when dependent on claim 2, wherein the inlet heat expansion element and the outlet heat expansion element comprise different heat expansion materials with different linear displacement profiles in different temperature ranges.

5. The system of any preceding claim, wherein an actuation of the inlet valve actuator and an actuation of the outlet valve actuator are both proportional to a temperature of the fluid within a defined range.

6. The system of any preceding claim, wherein the fluid control system is configured to maintain a constant difference in temperature between the incoming flow of the fluid and the outgoing flow of the fluid within a defined range of temperatures.

7. The system of claim 5, wherein the defined range is between 30°C and 60°C.

8. The system of any preceding claim, wherein the fluid inlet control valve comprises an expansion valve.

9. The system of any preceding claim, wherein the fluid inlet control valve comprises a gate valve.

10. The system of any preceding claim, further comprising:
a cabinet door, wherein the cabinet door comprises a liquid coolant circuit operatively coupled to the fluid inlet and the fluid outlet.

11. The system of any preceding claim, wherein the fluid outlet gate is disposed within the fluid outlet.

12. A method for controlling a flow of fluid within a cooling system to compensate for an increase in incoming fluid temperature, while maintaining a constant difference in temperature between an incoming flow of the fluid and an outgoing flow of the fluid, wherein the cooling system comprises a fluid control system, the method comprising:

transferring heat from an incoming fluid to a fluid inlet of the fluid control system;

transferring heat from the fluid inlet to an outlet valve actuator of a fluid outlet of the fluid control system;

actuating the outlet valve actuator based on a transfer of heat from the fluid inlet;

decreasing a restriction of the outgoing flow of the fluid by a fluid outlet gate of the fluid outlet; and

increasing the outgoing flow of the fluid based on a decrease in restriction by the fluid outlet gate.

13. The method of claim 12, further comprising;

increasing the temperature of an outgoing fluid based upon increase in incoming fluid temperature;

transferring heat from the outgoing fluid to a fluid outlet;

transferring heat from the fluid outlet to an inlet valve actuator;

actuating the inlet valve actuator based on the transfer of heat from the fluid outlet;

decreasing a restriction of the incoming flow of the fluid by a fluid inlet gate; and

increasing the incoming flow of the fluid based on a decrease in restriction by the fluid inlet gate.

FIG.1

FIG.2A

EP 4 650 630 A1

FIG.2B

EP 4 650 630 A1

Heat Expansion Element (Wax) Expansion as a Function of Temperature

FIG.3

400

Heat Expansion Element (Wax) Expansion as a Function of Temperature

FIG.4

EP 4 650 630 A1

Heat Expansion Element (Wax) Expansion as a Function of Temperature

FIG.5

FIG.6

RETURN TRANSLATION $X_r$

COMBINED TRANSLATION $X_c$

216

SUPPLY TRANSLATION $X_s$

FIG.7

800

810 — TRANSFERRING HEAT FROM AN INCOMING FLUID TO A FLUID INLET

820 — TRANSFERRING HEAT FROM THE FLUID INLET TO AN OUTLET VALVE ACTUATOR

830 — ACTUATING THE OUTLET VALVE ACTUATOR BASED ON A TRANSFER OF HEAT FROM THE FLUID INLET

840 — DECREASING A RESTRICTION OF THE OUTGOING FLOW OF THE FLUID BY A FLUID OUTLET GATE

850 — INCREASING THE OUTGOING FLOW OF THE FLUID BASED ON A DECREASE IN RESTRICTION BY THE FLUID OUTLET GATE

FIG.8A

800

860 — INCREASING THE TEMPERATURE OF AN OUTGOING FLUID BASED UPON THE INCREASE IN INCOMING FLUID TEMPERATURE

870 — TRANSFERRING HEAT FROM THE OUTGOING FLUID TO THE FLUID OUTLET

880 — TRANSFERRING HEAT FROM THE FLUID OUTLET TO THE INLET VALVE ACTUATOR

885 — ACTUATING THE INLET VALVE ACTUATOR BASED ON THE TRANSFER OF HEAT FROM THE FLUID OUTLET

890 — DECREASING A RESTRICTION OF THE INCOMING FLOW OF THE FLUID BY THE FLUID INLET GATE

895 — INCREASING THE INCOMING FLOW OF THE FLUID BASED ON A DECREASE IN RESTRICTION BY THE FLUID INLET GATE

FIG.8B

Europäisches
Patentamt

European
Patent Office

Office européen
des brevets

# EUROPEAN SEARCH REPORT

**Application Number**

EP 25 17 4640

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 108 119 674 A (GUANGZHOU ZILING INFORMATION TECH CO LTD) 5 June 2018 (2018-06-05) | 1,5-13 | INV. F16K3/02 F16K11/22 |
| Y | * figure 1 * * paragraph [0065] - paragraph [0075] * ----- | 2-4 | F16K31/00 H05K7/20 |
| Y | US 7 909 262 B2 (FLOW DESIGN INC [US]) 22 March 2011 (2011-03-22) * figure 2 * * column 3, line 23 - line 31 * ----- | 2-4 | |
| X | US 2017/254604 A1 (SHEPPARD JEFF [CA] ET AL) 7 September 2017 (2017-09-07) | 12,13 | |
| A | * figures 13, 14 * * paragraph [0035] - paragraph [0038] * ----- | 1-4 | |
| X | EP 3 531 031 B1 (HONEYWELL TECHNOLOGIES SARL [CH]) 21 July 2021 (2021-07-21) | 12,13 | |
| A | * figures 1, 3-8 * * paragraph [0034] - paragraph [0038] * ----- | 1,6 | |

**TECHNICAL FIELDS SEARCHED (IPC)**

F16K
H05K
F28F
G05D

The present search report has been drawn up for all claims

| Place of search | Date of completion of the search | Examiner |
|---|---|---|
| The Hague | 9 October 2025 | Silea, Cristian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 17 4640

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2025

| Patent document cited in search report | | Publication date | Patent family member(s) | | Publication date |
|---|---|---|---|---|---|
| CN 108119674 | A | 05-06-2018 | NONE | | |
| US 7909262 | B2 | 22-03-2011 | EP | 2095200 A2 | 02-09-2009 |
| | | | US | 2008210895 A1 | 04-09-2008 |
| | | | WO | 2008076864 A2 | 26-06-2008 |
| US 2017254604 | A1 | 07-09-2017 | CA | 2995890 A1 | 08-09-2017 |
| | | | CN | 108027085 A | 11-05-2018 |
| | | | DE | 112017001122 T5 | 15-11-2018 |
| | | | DE | 202017006735 U1 | 27-03-2018 |
| | | | GB | 2562558 A | 21-11-2018 |
| | | | KR | 20180121866 A | 09-11-2018 |
| | | | US | 2017254604 A1 | 07-09-2017 |
| | | | WO | 2017147699 A1 | 08-09-2017 |
| EP 3531031 | B1 | 21-07-2021 | NONE | | |

For more details about this annex : see Official Journal of the European Patent Office, No. 12/82

**REFERENCES CITED IN THE DESCRIPTION**

**Patent documents cited in the description**

- US 63647205
- US 19010025